# FASCICULE DE BREVET EUROPEEN

(11) **EP 1 374 249 B1**
(45) Date de publication et mention de la délivrance du brevet: **01.10.2008**
(21) Numéro de dépôt: 02722367.6
(22) Date de dépôt: 22.03.2002
(51) Int. Cl.: G11C 16/22

(54) **DISPOSITIF ET PROCEDE DE PROTECTION PARTIELLE EN LECTURE D'UNE MEMOIRE NON VOLATILE**
VORRICHTUNG UND VERFAHREN ZUR TEILWEISEN LESEBESCHÜTZUNG EINES NICHTFLÜCHTIGEN SPEICHERS
DEVICE AND METHOD FOR PARTIAL READ-PROTECTION OF A NON-VOLATILE STORAGE

(30) Priorité: 05.04.2001 FR 0104638
(43) Date de publication de la demande: 02.01.2004
(73) Titulaire: STmicroelectronics SA, 92120 Montrouge (FR)
(72) Inventeur: NARCHE, Pascal, F-13790 Peynier (FR)
(74) Mandataire: Bentz, Jean-Paul
(86) Numéro de dépôt international: PCT/FR2002/001018
(87) Numéro de publication internationale: WO 2002/082459

(56) Documents cités:
- US-A- 5 594 793
- US-A- 6 088 262
- US-A- 6 160 734

## Description

L'invention concerne les mémoires électroniques du type non volatile qui sont associées à un microcontrôleur de manière à permettre à ce dernier d'effectuer des opérations conformément à des instructions et données contenues dans les mémoires. Elle concerne plus particulièrement dans ces mémoires un dispositif et un procédé pour protéger une ou plusieurs parties ou secteurs ou zones de ces mémoires contre une lecture non autorisée.

Il est connu de protéger globalement une mémoire contre une écriture et/ou une lecture en interdisant l'accès en écriture et/ou en lecture de la mémoire dès qu'un bit de protection a été mis dans un certain état ou qu'un fusible a été "grillé".

Bien que la mémoire soit protégée en lecture, elle doit être cependant accessible en lecture lorsque cette lecture résulte d'une instruction d'un programme. En conséquence, une mémoire protégée en lecture doit aussi être protégée en écriture de manière à éviter qu'un fraudeur puisse écrire un programme d'instructions dans la mémoire accessible en écriture en vue de lire la mémoire protégée en lecture.

Une telle mémoire est connue du brevet US-A-6 160 734.

Un but de la présente invention est donc de réaliser un dispositif qui permet de protéger tout ou partie d'une mémoire électronique de type non volatile contre une lecture non autorisée, c'est-à-dire une lecture qui ne correspond pas à l'exécution d'un code d'instruction.

Ce but est atteint en protégeant contre la lecture certaines parties déterminées de la mémoire sauf lorsque l'on détecte que la prochaine instruction est contenue dans une adresse correspondant à l'une de ces parties déterminées, auquel cas la partie de mémoire correspondant à cette adresse cesse d'être protégée pour permettre la lecture du contenu de cette adresse.

A cet effet, chaque partie protégée contre la lecture est définie par ses codes d'adressage de sorte que leur décodage par un décodeur d'adresses fournit un signal de sélection de la mémoire. Ce signal de sélection n'autorise la lecture de cette partie protégée que si le microcontrôleur fournit un signal indiquant que l'opération a pour but d'exécuter le code contenu dans l'adresse.

Les parties qui peuvent être protégées contre la lecture sont déterminées par le décodeur d'adresses par construction de ce dernier et les parties qui seront effectivement protégées sont déterminées chacune par l'état d'une cellule de mémoire, état qui est fixé par le développeur. C'est le signal d'état de cette cellule de mémoire qui conditionne la prise en compte du signal du microcontrôleur indiquant qu'il s'agit d'une opération d'exécution du code.

L'invention concerne un dispositif de protection en lecture d'au moins une zone d'une mémoire non volatile, caractérisé en ce qu'il comprend :
- un décodeur d'adresses pour fournir sur une des bornes de sortie un signal d'adressage lorsque l'adresse correspond à une des zones protégées en lecture de la mémoire,
- une mémoire d'état par zone protégée en lecture pour fournir un signal d'état indiquant que la zone est protégée ou non en lecture,
- un décodeur d'instruction de programme pour fournir un signal de programme indiquant que l'opération d'adressage en cours correspond ou non à une instruction de programme, et
- un circuit logique, auquel sont appliqués le signal d'adressage, le signal d'état et le signal de programme, pour fournir un signal d'instruction de lecture de la zone protégée en lecture lorsque le signal de programme indique que l'opération d'adressage en cours concerne une instruction de programme .

Le circuit logique comprend par zone de mémoire protégée en lecture :
- une porte logique OU dont une des deux bornes d'entrée est connectée à la borne de sortie d'une mémoire d'état correspondant à la zone considérée et dont l'autre borne d'entrée est connectée à la borne de sortie du décodeur d'instruction de programme pour recevoir le signal de programme, et
- un circuit de verrouillage dont la borne d'entrée est connectée à la borne de sortie du décodeur d'adresses correspondant à la zone considérée, dont la borne d'entrée d'horloge est connectée à la borne de sortie de la porte logique OU et dont la borne de sortie est connectée à une des bornes d'entrée d'une porte logique ET 46,
ledit circuit logique comprenant, en outre, une porte logique ET dont les bornes d'entrée sont connectées respectivement aux bornes de sortie des circuits de verrouillage et aux bornes de sortie du décodeur d'adresses correspondant aux zones de mémoire non protégées en lecture.

L'invention concerne aussi un procédé pour protéger en lecture au moins une zone d'une mémoire non volatile, caractérisé en ce qu'il comprend les étapes suivantes consistant à :
(a) diviser la mémoire en une pluralité de zones,
(b) choisir au moins une zone pour être protégée en lecture,
(c) détecter l'adressage d'une cellule de la mémoire dans l'une des zones choisies,
(d) déterminer si l'adressage en cours concerne une instruction du programme en cours de déroulement, et
(e) autoriser la lecture de la cellule de mémoire dans la zone protégée en lecture si la réponse à l'étape (d) est positive et l'empêcher dans le cas contraire.

D'autres caractéristiques et avantages de la présente invention apparaîtront à la lecture de la description suivante d'un exemple particulier de réalisation, ladite description étant faite en relation avec les dessins joints dans lesquels :
- la figure 1 est un schéma montrant une certaine organisation de mémoire non volatile pour mettre oeuvre l'invention,
- la figure 2 est un diagramme explicatif du fonctionnement de principe du dispositif selon l'invention,
- la figure 3 est un schéma d'un dispositif de protection partielle en lecture d'une mémoire non volatile selon l'invention.

Pour mettre en oeuvre l'invention, une mémoire non volatile 10 prévue pour enregistrer les programmes à exécuter sous la commande d'un microcontrôleur 12, est divisée en plusieurs parties ou zones 14, 16 et 18, chaque partie étant affectée à une certaine catégorie de programmes .

Par exemple, la partie 14, appelée "BOOT" contient le programme de démarrage après une remise à zéro ; la partie 16, appelée "APPLI", contient le ou les programmes applicatifs ; la partie 18, appelée "SHADOW", contient le ou les programmes que le développeur souhaite interdire à une lecture autre que celle ayant pour but d'exécuter un code d'instruction.

En plus de la mémoire 10, il peut y avoir d'autres mémoires 20, appelées "AUTRES", qui sont, elles aussi, sous le contrôle du microcontrôleur 12.

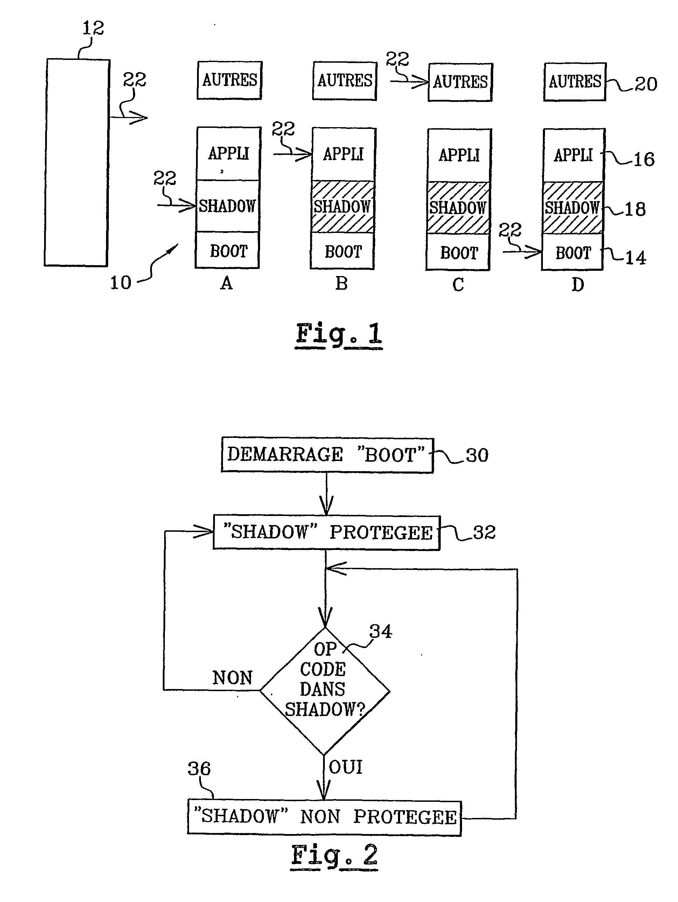

Le schéma de la figure 1 montre quatre cas d'adressage des mémoires 10 et 20.

Dans le premier cas A, le compteur de programme (flèche 22) du microcontrôleur 12 pointe une adresse de la partie "SHADOW" 18 de manière à lire le contenu à l'adresse pointée pour exécution. Cette partie 18 et les autres parties 14, 16 et 20 ne sont pas protégées en lecture.

Dans le deuxième cas B, le compteur de programme pointe une adresse de la partie "APPLI" 16. La partie "SHADOW" 18 est seule à être protégées en lecture (zone hachurée).

Dans le troisième cas C, le compteur de programme pointe une adresse de la partie "AUTRES" 20. Ici également, seule la partie "SHADOW" 18 est protégée en lecture.

Dans le quatrième cas D, le compteur de programme pointe une adresse de la partie "BOOT" 14. Seule la partie "SHADOW" 18 est protégée en lecture.

La partie "BOOT" 14 est la partie sans laquelle le microcontrôleur 12 ne peut démarrer.

La partie "SHADOW" 18 contient les programmes qu'un premier utilisateur de la carte écrit pour mettre en oeuvre les programmes applicatifs.

La partie "APPLI" 16 contient les programmes applicatifs qu'un deuxième utilisateur de la carte écrit.

Or, il peut être important que le deuxième utilisateur, ou utilisateur en second, ne puisse pas avoir accès en lecture aux programmes contenus dans la partie "SHADOW" 18 de manière à empêcher un piratage ou une fraude.

Selon l'invention, cette partie "SHADOW" 18 est interdite en lecture sauf si l'adressage effectué par le microcontrôleur 12 dans la partie SHADOW correspond à une exécution d'instruction.

La figure 2 montre le principe de fonctionnement de l'invention.

A la mise en marche, le programme "BOOT" 30 met la partie "SHADOW" 18 dans l'état de protection en lecture 32.

Le microcontrôleur 12 détermine si le prochain code d'exécution est enregistré dans la partie "SHADOW" (étape 34). En cas de réponse positive, la partie "SHADOW" cesse d'être protégée en lecture, c'est-à-dire que l'interdiction de lecture est levée (état 36).

En cas de réponse négative, la partie "SHADOW" reste protégée en lecture et aucune lecture n'est possible.

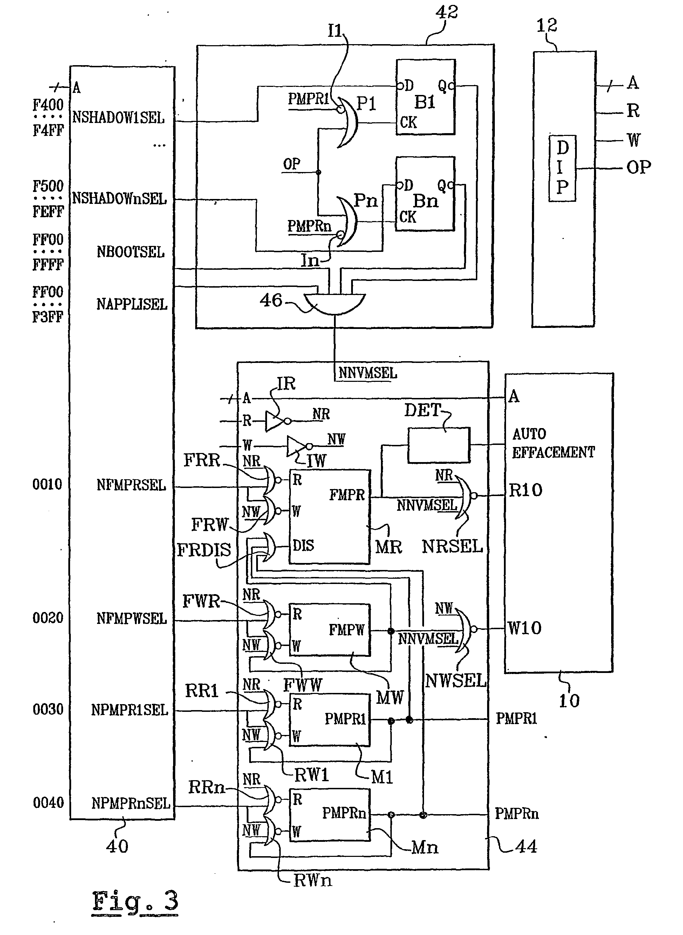

Un dispositif de protection partielle en lecture de la mémoire non volatile 10 sera décrit de manière détaillée en relation avec le schéma de la figure 3.

Ce dispositif est prévu pour utiliser au maximum n parties ou zones de type SHADOW qui sont déterminées par leur code d'adresse. Ces n zones de type SHADOW sont réparties à plusieurs endroits de la mémoire 10.

Le dispositif comprend :
- un décodeur d'adresses 40 qui reçoit les codes d'adresses A du microcontrôleur 12,
- un circuit logique de sélection 42, et
- un circuit d'enregistrement 44 des états de protection des n parties ou zones de type SHADOW ainsi que l'état global de protection de la mémoire 10 en écriture et lecture.

Le décodeur d'adresses 40 est de type classique et fournit des signaux indiquant quelle partie de la mémoire est adressée par un code A.

Ainsi, il fournit un signal NAPPLISEL lorsque le code d'adresse A correspond à une adresse de la partie APPLI de la mémoire 10, par exemple les codes hexadécimaux F000 à F3FF.

Il fournit un signal NBOOTSEL lorsque le code d'adresse A correspond à une adresse de la partie BOOT de la mémoire 10, par exemple les codes hexadécimaux FF00 à FFFF.

Il fournit un signal NSHADOW1SEL lorsque le code d'adresse A correspond à une adresse d'une première zone de type SHADOW de la mémoire 10, par exemple les codes hexadécimaux F400 à F4FF.

Il fournit un signal NSSHADOWnSEL lorsque le code d'adresse A correspond à une adresse d'une nième zone de type SHADOW de la mémoire 10.

Tous ces signaux de décodage sont appliqués au circuit logique de sélection 42 qui comprend :
- n circuits de verrouillage B1 à Bn de type D, un par zone de type SHADOW, dont la borne d'entrée D est connectée à une des bornes de sortie du décodeur d'adresses qui fournit l'un des signaux NSHADOW1SEL à NSHADOWnSEL,
- n portes OU P1 à Pn dont la borne de sortie est connectée à la borne horloge CK d'un des circuits de verrouillage B1 à Bn respectivement ; l'une des deux bornes d'entrée de chaque porte P1 à Pn est connectée à l'une des n mémoires d'état M1 à Mn du circuit d'enregistrement 44 par l'intermédiaire d'inverseurs I1 à In, tandis que l'autre borne d'entrée est connectée à une borne de sortie OP du microcontrôleur 12 dont le signal indique que le prochain code d'instruction est enregistré dans une zone de type SHADOW,
- un circuit ET 46 à (n + 2) bornes d'entrée qui sont connectées respectivement à la borne de sortie NAPPLISEL, et à la borne de sortie NBOOTSEL du décodeur d'adresses 40 ainsi qu'à une borne de sortie Q des n circuits de verrouillage B1 à Bn ; la borne de sortie du circuit ET 46 est connectée au circuit d'enregistrement 44.

Le circuit d'enregistrement 44 comprend :
- n mémoires d'état M1 à Mn pour enregistrer respectivement l'état de protection en lecture de chacune des zones de type SHADOW,
- une mémoire MW pour enregistrer l'état de protection globale en écriture de la mémoire 10,
- une mémoire MR pour enregistrer l'état de protection globale en lecture de la mémoire 10,
- et diverses portes logiques qui seront décrites ci-après.

Chaque mémoire d'état M1 à Mn ainsi que les mémoires MW et MR a deux bornes d'entrée R et W qui sont connectées à une borne de sortie du décodeur d'adresses 40 par l'intermédiaire d'une porte logique de type OU complémentaire, plus connue sous le terme porte NOR.

Ainsi, la borne de sortie NPMPR1SEL, correspondant au décodage du code 0030, est connectée à la borne d'entrée R de la mémoire M1 par une porte RR1 et à la borne d'entrée W par une porte RW1.

Il en est de même des autres bornes de sortie jusqu'à la nième borne NPMPRnSEL, correspondant au code 0040, qui est connectée à la borne d'entrée R de la mémoire Mn par une porte RRn et à la borne d'entrée W par une porte RWn.

De manière analogue, la borne de sortie NFPMWSEL, correspondant au code 0020, est connectée à la borne d'entrée R de la mémoire MW par une porte FWR et à la borne d'entrée W par une porte FWW.

La borne de sortie NFMPRSEL, correspondant au code 0010, est connectée à la borne d'entrée R de la mémoire MR par une porte FRR et à la borne d'entrée W par une porte FRW.

Ces portes logiques NOR ont chacune une deuxième borne d'entrée qui est connectée à la borne de sortie R ou W du microcontrôleur 10 par l'intermédiaire d'un circuit inverseur IR ou IW respectivement, les bornes de sortie fournissant les signaux R de lecture et W d'écriture.

Le circuit 44 comprend en outre deux autres portes logiques NOR référencées NRSEL et NWSEL dont la borne de sortie est connectée respectivement à la borne d'entrée R10 et à la borne d'entrée W10 de la mémoire 10.

La porte NRSEL comprend trois bornes d'entrée qui sont connectées, la première à la borne de sortie du circuit ET 46 du circuit 42 qui fournit le signal NNVMSEL, la deuxième à la borne de sortie de l'inverseur IR fournissant le signal NR et la troisième à la borne de sortie de la mémoire d'état MR.

La porte NWSEL comprend trois bornes d'entrée qui sont connectées la première à la borne de sortie de la porte ET 46 du circuit 42 qui fournit le signal NNVMSEL, la deuxième à la borne de sortie de l'inverseur IW fournissant le signal NW et la troisième à la borne de sortie de la mémoire d'état MW.

En plus des deux bornes d'entrée R et W, la mémoire d'état MR comprend une troisième borne d'entrée DIS qui est connectée à la borne de sortie d'une porte logique OU référencée FRDIS qui comprend (n + 1) bornes d'entrée. L'une de ces bornes d'entrée est connectée à la borne de sortie de la mémoire MW et les n autres aux bornes de sorties respectives des mémoires M1 à Mn.

Le circuit 44 comprend aussi un circuit détecteur DET de passage de "1" à "0" de la borne de sortie de la mémoire MR ; ce circuit détecteur fournit un signal d'effacement de la mémoire 10 qui est appliqué sur la borne d'entrée AUTOEFFACEMENT.

Il est à remarquer que les mémoires d'état MW et M1 à Mn ont leur borne d'entrée qui est rebouclée vers la borne d'entrée W par l'intermédiaire de la porte logique NOR correspondante. Ce montage a pour effet de ne permettre d'effectuer qu'une seule écriture dans la mémoire d'état.

Les mémoires d'état M1 à Mn ne sont mises à l'état 1 que si la partie de mémoire 10 correspondante doit être protégée en lecture, cette partie de mémoire étant déterminée respectivement par le signal de décodage NSHADOW1SEL à NSHADOWnSEL. Les mémoires d'état M1 à Mn sont sélectionnées respectivement en lecture ou écriture par les signaux de décodage NPMPR1SEL à NPMPRnSEL. Dès qu'une mémoire d'état M1 à Mn est mise à l'état 1 de protection en écriture, le signal de cet état 1 est appliquée à l'entrée d'écriture de la mémoire d'état via la porte RW1 à RWn de manière à confirmer cet état 1 et éviter que l'on puisse passer de l'état 1 à l'état 0.

La mémoire d'état MW enregistre un état 1 si toute la mémoire 10 est entièrement protégée en écriture et la boucle entre sa borne de sortie et sa borne d'entrée W via la porte FWW confirme cette protection de manière à éviter que l'on puisse passer de l'état 1 à l'état 0.

La mémoire d'état MR enregistre à l'état 1 le fait que toute la mémoire 10 est entièrement protégée en lecture comme pour les états 1 des mémoires d'état M1 à Mn qui signifient chacun une protection d'une partie de la mémoire 10. Cette mémoire d'état MR est sélectionnée en lecture ou écriture par un signal de décodage NFMPRSEL et sa borne de sortie est connectée à la troisième borne d'entrée de la porte NOR NRSEL et à un circuit détecteur DET de passage de l'état 1 à l'état 0.

Le fonctionnement du dispositif de la figure 3 sera maintenant décrit en supposant que la mémoire 10 est complètement protégée en écriture (FMPW = 1) et protégée en lecture pour la zone de mémoire 10 correspondant au signal de décodage NSHADOW1SEL (PMPR1 = 1). Les autres mémoires d'état MR et M2 (non représentée) à Mn sont à l'état 0, c'est-à-dire que les zones correspondantes ne sont pas protégées en lecture.

Si une adresse de sélection de la mémoire 10 provoque l'apparition du signal de décodage NSHADOW1SEL, ce dernier de niveau 0 est appliqué à la borne d'entrée D du circuit de verrouillage B1. Par ailleurs, le signal PMPR1, indiquant que cette zone de mémoire est protégée en lecture, est appliquée à la porte P1 via un circuit inverseur Il de sorte que la borne d'entrée est à l'état 0.

Si le microcontrôleur 12 ne fournit pas le signal OP indiquant qu'il s'agit d'une instruction, la porte P1 ne fournit aucun signal sur sa borne de sortie. La borne d'entrée d'horloge CK du circuit de verrouillage B1 ne reçoit donc aucun signal de sorte que l'état 0 de la borne d'entrée D n'est pas transmis sur la borne de sortie Q qui reste à l'état 1. Le signal de cet état 1, appliqué à la porte ET 46, fournit un signal d'état 1 sur la borne de sortie, état 1 qui est inactif, c'est-à-dire que le signal de sélection NNVMSEL est à l'état 1 de sorte que la borne de sortie de la porte NRSEL est à l'état 0 qui interdit la lecture. Si le microcontrôleur 12 fournit une impulsion OP, la porte OU P1 transmet cette impulsion OP qui, appliquée sur la borne d'entrée CK, transmet l'état de la borne d'entrée D vers la borne de sortie Q de sorte que cette dernière passe à l'état 0. Ce signal d'état 0, appliquée à la porte ET 46, fournit le signal de sélection NNVMSEL à la porte NRSEL. Les autres bornes d'entrée étant à l'état 0, la borne de sortie est à l'état 1 et autorise la lecture de la mémoire 10 à l'adresse indiquée.

Si une adresse de sélection de la mémoire 10 provoque l'apparition du signal de décodage NSHADOWnSEL, ce dernier de niveau 0 est appliqué à la borne d'entrée D du circuit de verrouillage Bn. Par ailleurs, le signal PMPRn = 0 indiquant que ce secteur de mémoire n'est pas protégée en lecture, est appliqué à la porte OU Pn via le circuit inverseur In, de sorte que la borne d'entrée correspondante est à l'état 1.

La borne de sortie de cette porte Pn est à l'état 1 et ce signal, appliqué à la borne CK, transmet l'état 0 de la borne d'entrée D vers la borne de sortie Q de sorte que le signal d'état 0 fournit le signal de sélection NNVMSEL qui permet la lecture d'une cellule de mémoire dans ce secteur que le signal OP soit présent (code d'instruction) ou absent (pas d'instruction).

Lorsqu'une zone de mémoire est protégée en lecture, elle est aussi protégée en écriture grâce à la mémoire d'état MW et à la porte NWSEL. En effet, le signal NNVMSEL est à l'état 0 de sorte que la borne de sortie de la porte NWSEL est à l'état 0 et interdit l'écriture.

Comme indiqué ci-dessus, les mémoires actuelles comprennent les mémoires d'état MW et MR qui ont pour but de permettre de protéger toute la mémoire entre un accès en écriture (FMPW = 1) ou en lecture (FMPR = 1).

Il est également prévu un détecteur DET de passage de la mémoire d'état MR de l'état 1 à l'état 0, auquel cas un dispositif de protection réalise un auto-effacement de toute la mémoire 10 car un tel changement d'état est considéré comme un essai de fraude pour lire la mémoire.

Cependant, pour la zone SHADOW protégée en lecture, il est nécessaire que FMPR = 0 d'où une possibilité de changement d'état de 1 à 0 et donc un auto-effacement. Pour empêcher ce changement d'état, la mémoire d'état MR ne peut enregistrer un état 0 lorsqu'il existe une zone SHADOW.

Ceci est obtenu par le circuit OU référencé FRDIS qui bloque l'écriture d'un zéro lorsque l'une des mémoires d'états M1 à Mn est à l'état 1.

Ce blocage de l'écriture d'un zéro intervient également lorsque la mémoire 10 est protégée en écriture avec FMPW = 1. Ce blocage est utilisé dans le cas où la mémoire 10 est une mémoire FLASH utilisée en mémoire permanente. A cet effet, toute la mémoire 10 est protégée en écriture car FMPW = 1 et par l'intermédiaire de la porte FRDIS, la mémoire d'état MR ne peut pas passer à l'état 0, ce qui bloque l'auto-effacement et empêche, par voie de conséquence, le ré-enregistrement de la mémoire FLASH.

La description ci-dessus permet de définir les étapes d'un procédé pour protéger en lecture au moins une zone d'une mémoire non volatile 10, caractérisé en ce qu'il comprend les étapes suivantes consistant à :
(a) diviser la mémoire 10 en une pluralité de zones,
(b) choisir au moins une zone pour être protégée en lecture,
(c) détecter l'adressage d'une cellule de la mémoire 10 dans l'une des zones choisies,
(d) déterminer l'adressage en cours concerne une instruction du programme en cours de déroulement, et
(e) autoriser la lecture de la cellule de mémoire dans la zone protégée en lecture si la réponse à l'étape (d) est positive et l'empêcher dans le cas contraire.

## Revendications

1. Dispositif de protection en lecture d'au moins une zone d'une mémoire non volatile (10), **caractérisé en ce qu'**il comprend :
- un décodeur d'adresses (40) pour fournir sur une des bornes de sortie un signal d'adressage (NSHADOW1SEL, NSHADOWnSEL) lorsque l'adresse correspond à une des zones protégées en lecture de la mémoire (10),
- une mémoire d'état (M1, Mn) par zone protégée en lecture pour fournir un signal d'état (PMPR1, PMPRn) indiquant que la zone est protégée ou non en lecture,
- un décodeur d'instructions de programme (DIP) pour fournir un signal de programme (OP) indiquant que l'opération d'adressage en cours correspond ou non à une instruction de programme, et
- un circuit logique (42), auquel sont appliqués le signal d'adressage (NSHADOW1SEL, NSHADOWnSEL), le signal d'état (PMPR1, PMPRn) et le signal de programme (OP), pour fournir un signal (R10) d'instruction de lecture de la zone protégée en lecture lorsque le signal de programme (OP) indique que l'opération d'adressage en cours concerne une instruction de programme.

2. Dispositif selon la revendication 1, **caractérisé en ce que** le circuit logique (42) comprend par zone de mémoire protégée en lecture :
- une porte logique OU (P1, Pn) dont une des deux bornes d'entrée est connectée à la borne de sortie d'une mémoire d'état (M1, Mn) correspondant à la zone considérée et dont l'autre borne d'entrée est connectée à la borne de sortie du décodeur d'instruction de programme (DIP) pour recevoir le signal de programme (OP), et
- un circuit de verrouillage (B1, Bn) dont la borne d'entrée (D) est connectée à la borne de sortie du décodeur d'adresses (40) correspondant à la zone considérée, dont la borne d'entrée d'horloge (CK) est connectée à la borne de sortie de la porte logique OU (P1, Pn) et dont la borne de sortie (Q) est connectée à une des bornes d'entrée d'une porte logique ET 46
ledit circuit logique (42) comprenant, en outre, une porte logique ET dont les bornes d'entrée sont connectées respectivement aux bornes de sortie (Q) des circuits de verrouillage (B1, Bn) et aux bornes de sortie du décodeur d'adresses (40) correspondant aux zones de mémoire prévues pour n'être pas protégées en lecture.

3. Dispositif selon la revendication 1 ou 2, **caractérisé en ce que** chaque mémoire d'état (M1, Mn) comprend une cellule de mémoire qui est sélectionnée en lecture ou écriture par un signal d'adresse (NPMPR1SEL, NPMPRnSEL) du décodeur d'adresses (40) et dont la borne de sortie est connectée à la borne d'entrée d'écriture de manière à interdire toute nouvelle écriture lorsque la cellule de mémoire a été mise dans l'état indiquant que la zone correspondante est protégée en écriture.

4. Dispositif selon la revendication 3, **caractérisé en ce qu'**il comprend, en outre,
- une mémoire d'état (MR) constituée d'une cellule de mémoire qui est sélectionnée en lecture ou écriture par un signal d'adressage (NFMPSEL) du décodeur d'adresses (40), un premier état « 1 » correspondant à une protection globale en lecture de la mémoire (10) et un deuxième état « 0 » correspondant à une absence de protection en lecture,
- un détecteur (DET) du passage de l'état « 1 » à l'état « 0 » de la mémoire d'état (MR) pour fournir un signal représentatif de ce passage de manière à commander l'auto-effacement de la mémoire (10), et
- une porte logique OU (FRDIS) dont les bornes d'entrée sont connectées aux bornes de sortie des mémoires d'état des zones susceptibles d'être protégées en lecture et dont la borne de sortie est connectée à la mémoire d'état (FMPR) indiquant la protection globale ou non en lecture de la mémoire (10) pour interdire l'écriture d'un état « 0 » lorsqu'une mémoire d'état de zone est dans l'état de protection en lecture et ainsi empêcher l'auto-effacement.

5. Dispositif selon la revendication 3 ou 4, **caractérisé en ce qu'**il comprend, en outre,
- une mémoire d'état (MW) constituée d'une cellule de mémoire qui est sélectionnée en lecture ou écriture par un signal d'adressage (NFMPWSEL) du décodeur d'adresses (40), un premier état « 1 » correspondant à une protection globale en écriture de la mémoire (10) et un deuxième état « 0 » correspondant à une absence de protection en écriture,
- une porte logique OU inversée (NWSEL) dont les bornes d'entrée reçoivent :
= la première un signal indiquant s'il s'agit d'une opération d'écriture ou non,
= la deuxième un signal indiquant si la sélection concerne une cellule d'une des zones protégées en lecture,
= la troisième le signal d'état de la mémoire d'état (MW) indiquant l'état de protection globale en écriture de la mémoire (10).
- **en ce que** la borne de sortie de la mémoire d'état (MW) de protection globale en écriture est connectée à une borne d'entrée du circuit OU (FRDIS) de manière à interdire l'auto-effacement de la mémoire (110) lorsque cette dernière est protégée globalement en écriture.

6. Procédé pour protéger en lecture au moins une zone d'une mémoire non volatile (10), **caractérisé en ce qu'**il comprend les étapes suivantes consistant à :
(a) diviser la mémoire (10) en une pluralité de zones,
(b) choisir au moins une zone pour être protégée en lecture,
(c) détecter l'adressage d'une cellule de la mémoire (10) dans l'une des zones choisies,
(d) déterminer que l'adressage en cours concerne une instruction du programme en cours de déroulement, et
(e) autoriser la lecture de la cellule de mémoire dans la zone protégée en lecture si la réponse à l'étape (d) est positive et l'empêcher dans le cas contraire.

## Claims

1. Device for read protection of at least one area of a non-volatile memory (10), **characterised in that** it comprises:
- an address decoder (40) to output an addressing signal (NSHADOW1SEL, NSHADOWnSEL) on one of the output terminals when the address corresponds to one of the read protected areas of the memory (10),
- a state memory (M1, Mn) for each read protected area to output a state signal (PMPR1, PMPRn) indicating whether or not the area is read protected,
- a program instructions decoder (DIP) to output a program signal (OP) indicating whether or not the current addressing operation corresponds to a program instruction, and
- a logic circuit (42) to which the addressing signal (NSHADOW1SEL, NSHADOWnSEL), the state signal (PMPR1, PMPRn) and the program signal (OP) are applied, in order to output an instruction signal (R10) to read the read protected area when the program signal (OP) indicates that the current addressing operation concerns a program instruction.

2. Device according to claim 1, **characterised in that** the logic circuit (42) comprises for each read protected memory area:
- a logical OR gate (P1, Pn), of which one of the two input terminals is connected to the output terminal of a state memory (M1, Mn) corresponding to the area considered, and of which the other input terminal is connected to the output terminal of the program instructions decoder (DIP) to receive the program signal (OP), and
- a locking circuit (B1, Bn), of which the input terminal (D) is connected to the output terminal of the address decoder (40) corresponding to the area considered, and of which the clock input terminal (CK) is connected to the output terminal of the logical OR gate (P1, Pn), and of which the output terminal (Q) is connected to one of the input terminals of a logical AND gate (46),
the said logic circuit (42) also comprising a logical AND gate of which the input terminals are connected to the output terminals (Q) of the locking circuits (B1, Bn) and to the output terminals of the address decoder (40) corresponding to the memory areas foreseen as not read protected, respectively.

3. Device according to claim 1 or 2, **characterised in that** each state memory (M1, Mn) comprises a memory cell selected in read or write by an address signal ((NPMPR1SEL, NPMPRnSEL) of the address decoder (40) and of which the output terminal is connected to the write input terminal to prevent any new write when the memory cell has been put in the state indicating that the corresponding area is write protected.

4. Device according to claim 3, **characterised in that** it also comprises:
- a state memory (MR) composed of a memory cell selected in read or in write by an addressing signal (NFMPSEL) of the address decoder (40), a first state "1" corresponding to a global read protection of the memory (10) and a second state "0" corresponding to a lack of read protection,
- a detector (DET) detecting when the state memory (MR) changes from state "1" to state "0" to output a signal representative of this change so as to control self erasing of the memory (10), and
- a logical OR gate (FRDIS) of which the input terminals are connected to the output terminals of the state memories of the areas that might be read protected and of which the output terminal is connected to the state memory (FMPR) indicating whether or not the memory (10) is globally read protected to prohibit writing a state "0" when an area state memory is in the read protection state and thus prevent the self erase.

5. Device according to claim 3 or 4, **characterised in that** it also comprises:
- a state memory (MW) composed of a memory cell selected in read or in write by an addressing signal (NFMPWSEL) of the address decoder (40), a first state "1" corresponding to a global write protection of the memory (10) and a second state "0" corresponding to a lack of write protection,
- a inverted logical OR gate (NWSEL), of which the input terminals receive:
= the first terminal, a signal indicating whether or not it is a write operation
= the second terminal, a signal indicating if the selection relates to a cell in one of the read protected areas
= the third terminal, the state signal of the state memory (MW) indicating the global write protection state of the memory (10).
- **in that** the output terminal of the global write protection state memory (MW) is connected to an input terminal of the OR circuit (FRDIS) to prevent a self erase of the memory (110) when the memory has a global write protection.

6. Method for providing read protection for at least one area of a non-volatile memory (10), **characterised in that** it comprises the following steps:
(a) divide the memory (10) into a plurality of areas,
(b) choose at least one area to be read protected,
(c) detect addressing of a cell in the memory (10) in one of the chosen areas,
(d) determine if the current addressing relates to an instruction of the program being currently executed, and
(e) enable reading of the memory cell in the read protected area if the response to step (d) is positive, and otherwise disable reading.

## Patentansprüche

1. Vorrichtung zum Leseschutz zumindest eines Bereiches eines nicht-flüchtigen Speichers (10), **dadurch gekennzeichnet, dass** sie aufweist:
- einen Adressendecoder (40) zum Liefern eines Adressiersignals (NSHADOW1SEL, NSHADOWnSEL) an eine der Ausgangsklemmen, wenn die Adresse einem der lesegeschützten Bereiche des Speichers (10) entspricht,
- einen Zustandsspeicher (M1, Mn) pro lesegeschützten Bereich zum Liefern eines Zustandssignals (PMPR1, PMPRn), welches anzeigt, ob der Bereich lesegeschützt ist oder nicht,
- einen Programmanweisungsdecoder (DIP) zum Liefern eines Programmsignals (OP), welches anzeigt, ob der laufende Adressiervorgang einer Programmanweisung entspricht oder nicht, und
- eine logische Schaltung (42), an welche das Adressiersignal (NSHADOW1SEL, NSHADOWnSEL), das Zustandssignal (PMPR1, PMPRn) und das Programmsignal (OP) gesendet werden, um ein Anweisungssignal (R10) zum Lesen des lesegeschützten Bereiches zu liefern, wenn das Programmsignal (OP) anzeigt, dass der laufende Adressiervorgang eine Programmanweisung betrifft.

2. Vorrichtung gemäß Anspruch 1, **dadurch gekennzeichnet, dass** die logische Schaltung (42) pro lesegeschützten Speicherbereich aufweist:
- ein logisches ODER-Glied (P1, Pn), dessen eine der beiden Eingangsklemmen an die Ausgangsklemme eines Zustandsspeichers (M1, Mn) entsprechend des betreffenden bereiches angeschlossen ist und dessen andere Eingangsklemme an die Ausgangsklemme des Programmanweisungsdecoders (DIP) angeschlossen ist, um das Programmsignal (OP) zu empfangen, und
- eine Sperrschaltung (B1, Bn), deren Eingangsklemme (D) an die Ausgangsklemme des dem betreffenden Bereich entsprechenden Adressendecoders (40) angeschlossen ist, deren Takteingangsklemme (CK) an die Ausgangsklemme des logischen ODER-Gliedes (P1, Pn) angeschlossen ist, und deren Ausgangsklemme (Q) an eine der Eingangsklemmen eines logischen UND-Gliedes (46) angeschlossen ist,
wobei die logische Schaltung (42) außerdem ein logisches UND-Glied aufweist, dessen Eingangsklemmen jeweils an die Ausgangsklemmen (Q) der Sperrschaltungen (B1, Bn) und an die Ausgangsklemmen des Adressendecoders (40) angeschlossen sind, der den Speicherbereichen entspricht, welche dafür vorgesehen sind nicht lesegeschützt zu sein.

3. Vorrichtung gemäß Anspruch 1 oder 2, **dadurch gekennzeichnet, dass** jeder Zustandsspeicher (M1, Mn) eine Speicherzelle aufweist, welche zum Lesen oder Schreiben von einem Adressensignal (NSHADOW1SEL, NSHADOWnSEL) des Adressendecoders (40) ausgewählt wird, und deren Ausgangsklemme an die Schreibeingangsklemme derart angeschlossen ist, dass jedes neue Schreiben verboten ist, wenn die Speicherzelle in den Zustand versetzt worden ist, der anzeigt, dass der entsprechende Bereich schreibgeschützt ist.

4. Vorrichtung gemäß Anspruch 3, **dadurch gekennzeichnet, dass** sie außerdem aufweist:
- einen Zustandsspeicher (MR), der von einer Speicherzelle gebildet ist, welche zum Lesen oder Schreiben von einem Adressiersignal (NFMPSEL) des Adressendecoders (40) ausgewählt wird, wobei ein erster Zustand "1" einem umfassenden Leseschutz des Speichers (10) und ein zweiter Zustand "0" einem Fehlen von Leseschutz entspricht,
- einen Detektor (DET) für den Übergang von dem Zustand "1" zum Zustand "0" des Zustandsspeichers (MR), um ein für diesen Übergang repräsentatives Signal derart zu liefern, dass das Selbstlöschen des Speichers (10) befohlen wird, und
- ein logisches ODER-Glied (FRDIS), dessen Eingangsklemmen an die Ausgangsklemmen der Zustandsspeicher der Bereiche angeschlossen sind, welche lesegeschützt werden können, und dessen Ausgangsklemme an den Zustandsspeicher (FMPR) angeschlossen ist, welcher den umfassenden Leseschutz oder nicht des Speichers (10) anzeigt, um das Schreiben eines Zustands "0" zu untersagen, wenn ein Bereichszustandsspeicher sich in dem lesegeschützten Zustand befindet, und somit das Selbstlöschen zu verhindern.

5. Vorrichtung gemäß Anspruch 3 oder 4, **dadurch gekennzeichnet, dass** sie außerdem aufweist:
- einen Zustandsspeicher (MW), der von einer Speicherzelle gebildet ist, welche zum Lesen oder Schreiben von einem Adressiersignal (NFMPWSEL) des Adressendecoders (40) ausgewählt wird, wobei ein erster Zustand "1" einem umfassenden Schreibschutz des Speichers (10) und ein zweiter Zustand "0" einem Fehlen von Schreibschutz entspricht,
- ein umgekehrtes logisches ODER-Glied (NWSEL), dessen Eingangsklemmen empfangen:
= die erste ein Signal, welches anzeigt, ob es sich um einen Schreibvorgang handelt oder nicht,
= die zweite ein Signal, welches anzeigt, ob die Auswahl eine Zelle eines der lesegeschützten Bereiche betrifft,
= die dritte das Zustandssignal des Zustandsspeichers (MW), welches den Zustand des umfassenden Schreibschutzes des Speichers (10) anzeigt,
- **dadurch**, dass die Ausgangsklemme des Zustandsspeichers (MW) des umfassenden Schreibschutzes an eine Ausgangsklemme der ODER-Schaltung (FRDIS) derart angeschlossen ist, dass das Selbstlöschen des Speichers (110) verboten ist, wenn dieser letztere umfassend schreibgeschützt ist.

6. Verfahren zum Leseschützen zumindest eines Bereiches eines nicht-flüchtigen Speichers (10), **dadurch gekennzeichnet, dass** es die folgenden Schritte aufweist, die daraus bestehen:
(a) den Speicher (10) in eine Vielzahl von Bereichen zu unterteilen,
(b) zumindest einen Bereich zu wählen, der lesegeschützt sein soll,
(c) die Adressierung einer Zelle des Speichers (10) in dem einen der gewählten Bereiche zu erfassen,
(d) zu bestimmen, dass die laufende Adressierung eine Anweisung des gerade ablaufenden Programms betrifft, und
(e) das Lesen der Speicherzelle in dem lesegeschützten Bereich zu erlauben, wenn die Antwort auf den Schritt (d) positiv ist und es im gegenteiligen Fall zu verhindern.
